Europäisches Patentamt

European Patent Office

Office européen des brevets

(11) Publication number: **0 195 611**
**A2**

## (12) EUROPEAN PATENT APPLICATION

(21) Application number: **86301850.3**

(22) Date of filing: **14.03.86**

(51) Int. Cl.⁴: **H 05 K 3/32**

(30) Priority: **16.03.85 GB 8506898**

(43) Date of publication of application:
**24.09.86 Bulletin 86/39**

(84) Designated Contracting States:
**AT BE CH DE FR IT LI LU NL SE**

(71) Applicant: **MARCONI ELECTRONIC DEVICES LIMITED**
**The Grove Warren Lane**
**Stanmore Middlesex HA7 4LY(GB)**

(72) Inventor: **Winter, Roy Charles**
**38, Okebourne Park Liden**
**Swindon Wiltshire(GB)**

(74) Representative: **Hoste, Colin Francis**
**The General Electric Company p.l.c. Central Patent**
**Department (Chelmsford Office) Marconi Research**
**Centre West Hanningfield Road**
**Great Baddow Chelmsford CM2 8HN, Essex(GB)**

(54) Printed electrical circuit and method of correcting components therewith.

㊿ An electrical circuit consists of one or more electrical or electronic components which are mounted on a substrate and form part of a circuit which is printed upon the substrate. The printed circuit consists of a low temperature cured polymer ink which also serves to secure the components to the substrate. The component leads are applied to the initially wet ink, and are retained in position by the ink when it cures.

EP 0 195 611 A2

0195611

I/7035/MEDL

## ELECTRICAL CIRCUIT

This invention relates to an electrical circuit of the kind which is formed upon an insulating substrate by the selective application of a suitable settable electrical fluid. Such a circuit is sometimes called a hybrid circuit and the fluid is generally termed an ink and is chosen with regard to its electrical properties. It may be an electrically conductive ink although resistive and dielectric inks are also used, depending on the circuit property required. In the process, the ink is applied to the surface of the substrate through a suitably shaped screen consisting of open portions in the form of a fine mesh.

Hitherto, the electrical inks have generally been of a kind which fire at very high temperatures, typically at about 850°C and this temperature is required in order to set the ink into a permanent state. Because of the high temperatures involved, the substrate has generally been of a refractory ceramic such as alumina. The use of such high temperatures, which necessitates the use of very expensive materials is generally undesired and it has been proposed to use polymer inks which cure at relatively low temperatures, of the order of 150°C. However, it has proved very difficult to use conventional solder techniques with these inks for the purpose of securing electrical components to the substrate. The present invention seeks to provide an improved electrical circuit in which electrical components are included.

According to this invention, a method of forming an electrical circuit upon an insulating substrate includes the steps of depositing regions of an electrical polymer ink on to the substrate; placing an electrical component in contact with the ink whilst the ink retains a degree of fluidity; and curing the ink so that it adheres both to the substrate and to the component so as to retain the component firmly in position.

Thus, in contrast to previous methods of fabricating electrical circuits which rely upon the selective application of an electrical ink, the electrical ink here acts as a kind of glue to hold the component firmly in place and the curing process is used not only to solidify the ink, but to procure the bond which serves to hold the electrical component firmly in place. This process avoids the need for separate and complex processing to permit the attachment of components to cured conductive patterns as has been customary in the past. It is particularly useful for surface mountable components as such components are becoming much more common and can be contrasted with the more traditional kind of components in which elongate conductive leads or wires are inserted through holes in the substrate in order to facilitate their attachment. In the case of surface mountable components, they are generally provided with projecting electrical leads which

- 3 -

0195611

are intended to mate face to face with a flat electrically conductive pad. Although they are generally designed to be attached by means of hot solder, nevertheless, the palladium-silver finish invariably applied to the leads to facilitate soldering, has proved unexpectedly to be especially suitable for forming a firm adhesive bond with a curing ink.

Preferably, the substrate is a thermosetting plastics material and the electrical ink used is a polymer ink of the kind which cures at a temperature in the region of $150^{O}C$. This permits the curing process to take place without risk of serious damage to electrical components which are generally able to withstand this temperature for prolonged periods without risk of deterioration. This is in complete contrast to the previously used ceramic based inks which were cured at temperatures of the order of $850^{O}C$. Because electronic components cannot withstand anything like these very high temperatures, it was necessary to fabricate the electrical circuit as an entity and after fabrication was completed, to add inividual electronic components as necessary. The use of the invention permits a very great simplification of the process by enabling superfluous processing steps to be eliminated.

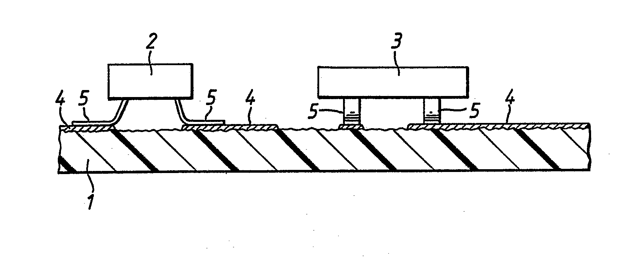

The invention is further described by way of example, with reference to the accompanying drawing which shows a sectional view through part of an electrical circuit.

The circuit is formed upon an electrically insulating substrate 1 which is formed of a moulded plastics material, typically a polysulfone, which can be injection moulded into any required shape under conditions of pressure and temperature, the temperature of the mould typically being about 95$^\circ$C, that of the material being about 395$^\circ$C, and the pressure is about 1380 Bar. Upon the plastics substrate, conductive inks can be printed using a conventional screen printing technique, in which a photosensitive emulsion is spread over a fine screen so as to fill the open mesh. An image corresponding to the required circuit pattern is projected on to the photosensitive emulsion so as to enable portions of it to be set in place. Unwanted regions of the emulsion are then removed in conventional manner to leave open mesh portions through which the conductive ink can be pressed by means of a squeegee or roller.

The conductive ink used is a low-temperature curing ink and is frequently termed a polymer ink. It is available from Electro-Science Laboratories Inc., in suitable types which can be conductive, resistive or dielectric. In order to enhance the adhesion of the ink to the substrate when the ink is subsequently cured, it is preferred to provide a roughened upper surface to the substrate, and this roughness can be incoporated into the substrate at the time it is moulded, or it can be imparted subsequent to manufacture by means of a sand-blasting technique or by the use of a plasma etch. It is much preferred to mould the roughness into the plastic in the first instance since the required degree of roughness can be determined by the use of the carefully prepared metal mould tool. The degree of roughness on the metal mould tool can be produced by a spark erosion technique. Alternatively, the roughness can be produced by a chemical etchant or by sand blasting. The degree of roughness required although not critical, must be kept within close limits. Typical values are 33 on the VDI scale and 4.5 on the RA scale, the two scales being inter-changeable. Significantly lesser degrees of roughness result in an appreciably poorer bond, but an increased degree of roughness may impair the fine geometry resolution which can be obtained, as it is difficult to lay down a very fine line of ink, or conversely a very fine gap between two ink regions, if the ink is laid down upon a very coarse undulating surface.

In accordance with this invention, an electrical or electronic component 2 or 3 is pressed into the fluid surface of the ink 4 whilst the ink is still in a wet fluid state. The ink is then cured in the required manner at a temperature of about $150^{o}C$ whilst the components are retained in position on the substrate. As the ink cures, it forms a strong bond with the roughened surface of the substrate 1 and also serves to adhere very well to the leads 5 of the electrical components. These leads are typically of a kind designed to accept the application of hot solder but it has been found that the palladium-silver surface finish is particularly suitable for forming a strong bond with the ink as it is cured. It is therefore unnecessary to attach the eletronic components to a cured ink as a separate step.

It will be noted that the ink 4 serves not only to retain the components 2 and 3 in place, but also it serves the primary function of defining the configuration and geometry of the circuit itself. Thus, in some instances, the major part of the circuit may consist of a complex pattern of conductive tracks, pads and also resistors formed using resistive inks, with just a few additional components being mounted in accordance with the invention. The components form part of the electrical circuit which is also partly defined by the pattern of conductive ink, and thus the adhesive ink serves not only to secure the components to the substrate, but also to interconnect them as necessary to each other and to other parts of the electrical circuit.

In any event, it has proved extremely difficult to succesfully apply hot solder to a cured polymer ink in a manner which is analogous to the ready application of hot solder to a cured ceramic ink. The hot solder rapidly damages and even destroys the polymer ink, rendering the use of much more complex processes necessary in order to ensure the satisfactory attachment of surface mounted components

CLAIMS

1.    A  method  of forming an electrical circuit upon  an insulating  substrate  including the steps  of  depositing regions of an electrical polymer ink on to the  substrate; placing  an  electrical component in contact with the  ink whilst  the ink retains a degree of fluditiy;  and  curing the  ink so that it adheres both to the substrate  and  to the  component  so  as to retain the component  firmly  in position.

2.    A  method  as  claimed in claim 1  and  wherein  the substrate  is  a thermosetting plastics material  and  the electrical  ink  used is a polymer ink of the  kind  which cures at a temperature in the region of 150$^{o}$C.

3.    A method as claimed in claim 1 or 2 and wherein  the polymer  ink is deposited on to roughened surface  regions of the substrate.

4.    An  electrical  circuit  including  an  electrically insulating  substrate;  the  substrate  carrying  a  cured electrical  polymer  ink  which  serves  to  secure  an electrical component to the substrate.

5.    An  electrical  circuit  including  an  electrically insulating  substrate  formed of a  moulded  thermosetting plastics  material;  the  substrate  carrying  a  cured electrical  polymer ink which defines a  required  circuit pattern;  and  one or more electrical components which are secured to the substrate by regions of the cured ink.